(19) Europäisches Patentamt
European Patent Office
Office européen des brevets

(11) **EP 2 610 284 A2**

(12) # DEMANDE DE BREVET EUROPEEN

(43) Date de publication:
**03.07.2013 Bulletin 2013/27**

(21) Numéro de dépôt: **12199838.9**

(22) Date de dépôt: **31.12.2012**

(51) Int Cl.:
**C08J 5/18** (2006.01)　　　**G01N 29/07** (2006.01)
**H01L 31/048** (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **30.12.2011　FR 1162594**

(71) Demandeur: **Toray Films Europe**
**01700 Saint-Maurice-de-Beynost (FR)**

(72) Inventeurs:
• **Lacrampe, Valérie**
**01700 SAINT-MAURICE-DE-BEYNOST (FR)**
• **Billard, Karine**
**01700 BEYNOST (FR)**
• **Stevenson, Timothy**
**01700 SAINT-MAURICE-DE- BEYNOST (FR)**

(74) Mandataire: **Cabinet Plasseraud**
**235 Cours Lafayette**
**69006 Lyon (FR)**

(54) **Procédé de fabrication d'un film polyester bietire**

(57)　L'invention concerne un procédé de fabrication d'un film polyester, de préférence un film polyéthylène téréphtalate PET, biétiré et comprenant des cristallites; caractérisé en ce qu'il comprend les étapes suivantes (a) Mise en oeuvre de granulés, à base de polyester (15000 et 50000D), et de viscosité intrinsèque comprise entre 0,4 et 1,3 dL/g; (b)Séchage des granulés; (c) Eventuel mélange; (d) Extrusion; (e) Refroidissement; (f) Eventuelle enduction ; (g)Etirage biaxial du film; (h) Eventuelle enduction; (i)Thermofixation; (j)Relaxation; (k)Bobinage du film, (1)Finition; (m) Contrôle des performances du film polyester par une méthode A de mesure de la résistance au choc-traction et/ou une méthode B de mesure de module sonique; (n) Prise en compte des mesures de l'étape (m) pour modifier au besoin les paramètres d'au moins l'une des étapes suivantes : (g) et (i), de façon à contrôler la résistance à l'hydrolyse du film.

L'invention concerne également un film polyester biétiré obtenu par le procédé selon l'invention, doté d'une résistance à l'hydrolyse mesurée dans un test PCT 36h 125°C et donnée par un taux de rétention de l'Allongement à la Rupture (AR) sens MD >70% ; d'une résistance au choc-traction en kJ/m$^2$ >300; et/ou par une valeur de module sonique planaire global GPSM en daN/mm$^2$ >470.

L'invention vise enfin un module, un panneau ou une cellule photovoltaïque équipé d'au moins un film selon l'invention.

**EP 2 610 284 A2**

**Description**

**Domaine de l'invention**

Le domaine de l'invention est celui de la fabrication de films polyesters, en particulier les films polyesters aromatiques tels que le polyéthylène téréphtalate (PET), le polyéthylène naphtalate (PEN) ou le polyéthylène téréphtalate (PBT) (e.g. à orientation bi-axiale).

En particulier, l'invention concerne la fabrication de films polyesters biétirés, monocouches ou multicouches résistant à l'hydrolyse.

**Généralités**

Les films polyesters, notamment PET, biétirés, monocouches ou multicouches sont d'usage très répandu du fait de leurs excellentes propriétés bien connues de stabilité thermique, de stabilité dimensionnelle, de résistance chimique et d'énergie de surface relativement élevée. Ces films sont utilisés en tant que films de protection pour une grande variété d'éléments, par exemple en tant que films pour applications extérieures contraignantes et notamment en tant que films constituant les faces arrière des panneaux photovoltaïques.

Ces applications requièrent notamment que les films soient dotés de bonnes propriétés de résistance à l'hydrolyse dans diverses conditions, et en particulier des conditions extérieures contraignantes. Il en est par exemple, ainsi, des films de "lamination" pour toitures (tôles ondulées transparentes), pour fenêtres ("lamination" sur PVC ou aluminium pour encadrement), des films adhésifs pour voitures et surtout des films utilisés dans les panneaux solaires photovoltaïques (PV), dans lesquels la stabilité des propriétés (notamment résistance à l'hydrolyse-adhésion) est requise pour de longues durées, au-delà de 20 ans.

Les panneaux PV regroupent des cellules PV enveloppées par des éléments qui lui confèrent une protection par rapport aux agents externes (pluie, chocs, variations de température...) et la rigidité nécessaire pour pouvoir être fixées aux structures qui les supportent. Ces éléments enveloppant sont e.g. les suivants:

- ● Encapsulant constitué d'un matériau devant présenter une bonne transmission de la lumière et une très faible sensibilité à la dégradation sous l'action du rayonnement UV.
- ● Couverture extérieure réalisée dans un matériau favorisant la transmission de la lumière et permettant de résister aux conditions climatologiques sévères.
- ● Couverture postérieure ou face arrière constituée d'un assemblage de films polymères destinés à favoriser l'intégrité et la rigidité du panneau et présentant une perte minime de performances en présence d'humidité, de chaleur et de rayonnement UV.
- ● Encadrement en métal, normalement en aluminium, qui assure rigidité et étanchéité à l'ensemble, et qui comprend les éléments nécessaires (généralement des forets) pour le montage du panneau sur la structure support.
- ● Boîte à terminaux incorporant les bornes pour la connexion du panneau PV.

Les films polymères assemblés pour constituer la face arrière du panneau PV, qui peuvent être des films polyesters, doivent être dotés d'une durabilité en termes de résistance à l'hydrolyse.

Or, l'une des contraintes auxquelles les fabricants de tels films polyesters ont à faire face, est la maîtrise au stade de la fabrication des propriétés finales recherchées pour ces films, en particulier la résistance à l'hydrolyse.

A ce jour, les fabricants de ces films polyesters ne connaissent que des méthodes prédictives dites "accélérées" qui restent lourdes, longues et coûteuses [Damp Heat Test (DHT) 85°C et 85% HR, Pressure Cooker Test (PCT)...] pour évaluer les performances de résistance à l'hydrolyse. Par exemple, il est généralement admis que 36h de PCT sont équivalents à environ 1500h de DHT, ce qui représente environ 20 ans de vieillissement naturel. Ces durées PCT & DHT, dont on peut se contenter au stade du pilote, sont difficilement compatibles avec un procédé de fabrication industrielle de polyester(s) (*e.g.* PET) à grande échelle et à grande vitesse. Ainsi ces méthodes prédictives connues ne permettent pas aux fabricants de films de modifier les paramètres de leur procédé, en fonction des résultats du test, dans des délais compatibles avec un cycle de production.

**Objectifs de l'invention**

Dans ce contexte, l'invention vise à satisfaire au moins l'un des objectifs suivants:

1. fournir un procédé de fabrication de films polyesters biétirés, monocouches ou multicouches, résistants à l'hydrolyse;
2. fournir une méthode de mesure sur films polyesters biétirés, monocouches ou multicouches, permettant le contrôle de la résistance à l'hydrolyse des films fabriqués;

3. fournir une méthode de mesure prédictive et rapide sur films polyesters biétirés, monocouches ou multicouches, qui, tout en satisfaisant aux objectifs 1 & 2 ci-dessus reste économique et compatible avec les exigences industrielles de rentabilité et de productivité.

4. fournir une méthode de mesure prédictive, rapide et universelle permettant l'évaluation de la résistance à l'hydrolyse sur tout type de films (opaques, blancs, troubles, transparents, contenant des mélanges de polymères et/ou charges incompatibles)

5. fournir un procédé de fabrication de films polyesters biétirés, monocouches ou multicouches, non seulement résistant à l'hydrolyse, mais aussi présentant au moins l'une des propriétés suivantes :

(i) transparents ;
(ii) adhésion améliorée;
(iii) anti-UV;
(iv) ne présentant que peu ou pas de poudrage au vieillissement;
(v) opacité améliorée;
(vi) blancheur et réflectivité améliorées;
(vii) stabilité à la lumière améliorée ;
(viii) résistants aux rayures ;
(ix) cohésifs ;
(x) antireflets ;
(xi) antistatiques ;

6. fournir des films polyesters biétirés, monocouches ou multicouches, résistant à l'hydrolyse;

7. fournir des films polyesters biétirés, monocouches ou multicouches, dont les propriétés d'usage, dont notamment la résistance à l'hydrolyse, sont prédéterminables et ajustables lors de la fabrication ;

8. fournir des films polyesters biétirés, monocouches ou multicouches, qui, tout en satisfaisant aux objectifs 4 & 5 ci-dessus, sont économiques et faciles à obtenir à l'échelle industrielle;

9. fournir des films polyesters biétirés, monocouches ou multicouches non seulement résistant à l'hydrolyse, mais aussi présentant au moins l'une des propriétés suivantes :

(i) transparents ;
(ii) adhésion améliorée ;
(iii) anti-UV;
(iv) ne présentant que peu ou pas de poudrage au vieillissement;
(v) opacité améliorée;
(vi) blancheur et réflectivité améliorées;
(vii) stabilité à la lumière améliorée ;
(viii) résistants aux rayures ;
(ix) cohésifs,
(x) antireflets ;
(xi) antistatiques ;

10. fournir des films polyesters biétirés monocouches ou multicouches répondant aux objectifs ci-dessus et pouvant être assemblés pour constituer la face arrière de panneaux PV.

**Brève description de l'invention**

Ces objectifs, parmi d'autres, sont atteints par la présente invention qui concerne, dans un premier aspect, un procédé de fabrication d'un film polyester, de préférence un film polyéthylène téréphtalate PET, biétiré, caractérisé en ce qu'il comprend les étapes suivantes:

(a) Mise en oeuvre d'une matière première constituée d'éléments discrets, de préférence des granulés, à base de polyester de poids moléculaire moyen en nombre compris entre 15000 et 50000, de préférence entre 18000 et 40000, et une viscosité intrinsèque (IV) comprise entre 0,4 et 1,3 dL/g, de préférence entre 0,6 et 1,2 dL/g;
(b) Séchage de la matière première;
(c) Eventuel mélange de la matière première;
(d) Extrusion (alimentation, compression, fusion et homogénéisation) de la matière première au travers d'au moins une filière pour former un film mono ou multicouche;

(e) Refroidissement du film extrudé à l'étape (d);

(f) Eventuelle enduction sur une face ou deux faces du film à l'aide de résine(s), de façon à conférer des propriétés spécifiques au film;

(g) Etirage biaxial du film obtenu à l'étape (e) selon un taux d'étirage et à une température d'étirage choisis de manière à orienter les chaines macromoléculaires selon 2 axes privilégiés dans le plan du film et à obtenir un taux de cristallinité représentant de 10 à 50 %, de préférence de 25 à 35 % en poids du film,;

(h) Eventuelle enduction sur une face ou deux faces du film à l'aide de résine(s), de façon à conférer des propriétés spécifiques au film;

(i) Thermofixation du film,

(j) Relaxation transversale du film,

(k) Bobinage du film,

(l) Finition du film choisie de préférence dans le groupe constitué par : découpage, enduction, métallisation sous vide, recuit, traitement UV, plasma ou corona, et leurs combinaisons ;

(m) Contrôle des performances du film polyester par la méthode A de mesure de la résistance au choc-traction et/ou la méthode B de mesure de module sonique;

(n) Prise en compte des mesures de l'étape (m) pour modifier les paramètres d'au moins l'une des étapes suivantes : (g) et (i), de façon à contrôler la résistance à l'hydrolyse du film.

Le procédé suivant l'invention permet donc d'accéder à des films polyesters, de préférence PET, biétirés dotés de propriétés notamment de résistance à l'hydrolyse améliorées et ajustables. Il est en outre économique, rapide et simple à mettre en oeuvre. Conformément à l'invention, l'étape (m) de contrôle du film est réalisable dans un temps compatible avec le cycle de production, par les méthodes de mesure A et/ou B originales, rapides, universelles et prédictives du comportement à l'hydrolyse d'un film polyester, de préférence un film PET ;

Suivant un autre de ses aspects, l'invention concerne deux méthodes A et B prédictives, rapides, universelles et réalisables dans un temps compatible avec les cycles de production, de mesure de la résistance à l'hydrolyse sur films polyester : mesure de résistance au choc-traction (méthode A) et mesure de module sonique (méthode B) ;

Suivant un autre de ses aspects, l'invention concerne un film polyester biétiré notamment celui obtenu par le procédé selon l'invention, évalué par les méthodes prédictives et présentant une résistance à l'hydrolyse améliorée, mesurée dans un test PCT 36h 125°C sens MD et donnée par le pourcentage de rétention de l'allongement à la rupture.

Suivant encore un autre de ses aspects, l'invention concerne un panneau ou cellule photovoltaïque équipé d'au moins un film selon l'invention ;

Suivant encore un autre de ses aspects, l'invention concerne l'utilisation d'au moins un film selon l'invention, pour la fabrication d'un panneau ou d'une cellule photovoltaïque, en particulier de la face arrière dudit panneau ou de ladite cellule.

*Définitions*

Dans le présent exposé, tout singulier désigne indifféremment un singulier et un pluriel et réciproquement, sauf indication contraire expresse.

Les définitions suivantes sont données à titre d'exemples pour l'interprétation du présent exposé.

Par *"polymère"* on entend homopolymère ou copolymère.

Par *"polyester"* on entend tout polymère dont les motifs de répétition de la chaîne principale contiennent la fonction ester.

Par *"résistance à l'hydrolyse"* on entend capacité du film à conserver ses performances mécaniques en milieu humide.

Par *"résistance au choc-traction"*, on entend la mesure de l'énergie absorbée lors de la rupture d'une éprouvette non entaillée exprimée en $kJ/m^2$ selon la norme ISO-8256 telle que définie ci-après dans les exemples.

Par *"Méthode A"*, on entend une méthode de mesure de la *"résistance au choc-traction", telle* que visée au paragraphe précédent et définie plus en détail dans les exemples.

Par *"module sonique"*, on entend la valeur empirique calculée à partir de la vitesse de propagation des ondes ultrasoniques dans le plan du film exprimée en $daN/mm^2$ telle que définie ci-après dans les exemples.

Par *"Méthode B "*, on entend une méthode de mesure du *"module sonique "*, telle que visée au paragraphe précédent et définie plus en détail dans les exemples.

Par *"test PCT "*, on entend test de vieillissement accéléré en température et en pression à 100% d'humidité relative pendant un certain nombre d'heures, tel que défini ci-après dans les exemples.

Par « IV » on entend viscosité intrinsèque de l'échantillon polymère ou film, telle que définie ci-après dans les exemples.

Par *"compris entre x et y "*, on entend un ou des intervalles de valeurs dont les bornes sont fermées : [x,y].

*Préférences*

Suivant une caractéristique remarquable de l'invention, les résultats obtenus par les méthodes de mesure A et/ou B adoptées dans l'étape (m) du procédé de fabrication sont pris en compte lors de l'étape (n) pour agir sur les paramètres d'au moins l'une des étapes du procédé de fabrication du film polyester biorienté suivantes : (g) et (i), afin d'ajuster les propriétés de résistance à l'hydrolyse du film en cours de fabrication.

Selon une première possibilité de mise en oeuvre de l'invention, le procédé de fabrication d'un film polyester comprend au moins l'un des trois modes (I, II, III) suivants de contrôle des paramètres opératoires, ces 3 modes étant donnés ci-après dans un ordre décroissant de préférence:

I. Pour obtenir une résistance au choc-traction du film mesurée par la méthode A supérieure à 300 kJ/m$^2$, et par suite une résistance à l'hydrolyse mesurée dans un test PCT 36h 125°C et donnée par un taux de rétention de l'Allongement à la Rupture (AR) sens MD supérieur à 70%;

- l'étirage longitudinal est effectué avec un taux d'étirage compris dans les intervalles suivants donnés dans un ordre croissant de préférence : [2 ; 6] ; [2,5 ; 5]; [2,9 ; 4,5]; à une température (°C) d'étirage comprise dans les intervalles suivants donnés dans un ordre croissant de préférence [70 ; 150] [85 ; 140] ; [90 ; 135];
- l'étirage transversal est effectué avec un taux d'étirage compris dans les intervalles suivants donnés dans un ordre croissant de préférence : [2 ; 6] ; [3,5 ; 5]; [3,9 ; 4,5]; à une température (°C) d'étirage comprise dans les intervalles suivants donnés dans un ordre croissant de préférence : [95 ; 150] [105 ; 145] ; [110 ; 140]
- l'étirage surfacique (taux d'étirage longitudinal * taux d'étirage transversal) est compris dans les intervalles suivants donnés dans un ordre croissant de préférence : [4 et 25] ; [7 et 25] ; [11 ;25] .

II. Pour obtenir une résistance au choc-traction du film mesurée par la méthode A comprise entre 240 et 300 kJ/m$^2$, et par suite une résistance à l'hydrolyse mesurée dans un test PCT 36h 125°C et donnée par un taux de rétention de l'Allongement à la Rupture (AR) sens MD, compris entre 50 et 70% On met en oeuvre une étape (g) d'étirage avec des paramètres choisis tels que:

- l'étirage longitudinal est effectué avec un taux d'étirage compris entre 2 et 6, de préférence entre 2,5 et 5; à une température (°C) d'étirage comprise entre 70 et 150, de préférence entre 85 et 140, et, plus préférentiellement encore entre 90 et 140;
- l'étirage transversal est effectué avec un taux d'étirage compris entre 2 et 6, de préférence entre 3,5 et 5; à une température (°C) d'étirage comprise entre 95 et 150, de préférence entre 105 et 145, et, plus préférentiellement encore entre 110 et 145;
- l'étirage surfacique (taux d'étirage longitudinal * taux d'étirage transversal) est compris entre 4 et 25 et de préférence entre 4 et 20;

III. Pour obtenir une résistance au choc-traction du film mesurée par la méthode A inférieure à 240 kJ/m$^2$, et par suite une résistance à l'hydrolyse mesurée dans un test PCT 36h 125°C et donnée par un taux de rétention de l'Allongement à la Rupture (AR) sens MD inférieur à 50% :

- l'étirage longitudinal est effectué avec un taux d'étirage compris entre [2 ; 6] ; à une température (°C) d'étirage comprise dans les intervalles suivants donnés dans un ordre croissant de préférence : [70 ; 150]; [85 ; 150]; [95;145];
- l'étirage transversal est effectué avec un taux d'étirage compris entre [2 ; 6] ; à une température (°C) d'étirage comprise dans les intervalles suivants donnés dans un ordre croissant de préférence : [95 ; 150]; [105 ; 150]; [110 ; 150];
- l'étirage surfacique (taux d'étirage longitudinal * taux d'étirage transversal) est compris entre 4 et 25, de préférence entre 4 et 20 et plus préférentiellement encore entre 4 et 12.

Selon une deuxième possibilité de mise en oeuvre de l'invention, le procédé de fabrication d'un film polyester comprend au moins l'un des trois modes (IV, V, VI) suivants de contrôle des paramètres opératoires, ces 3 modes étant donnés ci-après dans un ordre décroissant de préférence:

IV. Pour obtenir une valeur de module sonique planaire global GPSM mesurée par la méthode B supérieure à 470 daN/mm$^2$, et par suite une résistance à l'hydrolyse mesurée dans un test PCT 36h 125°C et donnée par un taux de rétention de l'Allongement à la Rupture (AR) sens MD supérieur à 70%:

- l'étirage longitudinal est effectué avec un taux d'étirage compris dans les intervalles suivants donnés dans un ordre croissant de préférence : [2 ; 6] ; [2,5 ; 5]; [2,9 ; 4,5]; à une température (°C) d'étirage comprise dans les intervalles suivants donnés dans un ordre croissant de préférence [70 ; 150] [85 ; 140] ; [90 ; 135];
- l'étirage transversal est effectué avec un taux d'étirage compris dans les intervalles suivants donnés dans un ordre croissant de préférence : [2 ; 6] ; [3,5 ; 5]; [3,9 ; 4,5]; à une température (°C) d'étirage comprise dans les intervalles suivants donnés dans un ordre croissant de préférence : [95 ; 150] [105 ; 145] ; [110 ; 140];
- l'étirage surfacique (taux d'étirage longitudinal * taux d'étirage transversal) est compris dans les intervalles suivants donnés dans un ordre croissant de préférence : [4 et 25] ; [7 et 25] ; [11 ;25];

V. Pour obtenir une valeur de module sonique planaire global GPSM mesurée par la méthode B comprise entre 440 et 470 daN/mm$^2$, et par suite une résistance à l'hydrolyse mesurée dans un test PCT 36h 125°C et donnée par un taux de rétention de l'Allongement à la Rupture (AR) sens MD compris entre 50 et 70%: On met en oeuvre une étape (g) d'étirage avec des paramètres choisis tels que:

- l'étirage longitudinal est effectué avec un taux d'étirage compris dans les intervalles suivants donnés dans un ordre croissant de préférence [2 ; 6] ; [2,5 ; 5]; à une température (°C) d'étirage comprise dans les intervalles suivants donnés dans un ordre croissant de préférence [70 ; 150] [85 ; 140] ; [90 ; 140];
- l'étirage transversal est effectué avec un taux d'étirage compris entre les intervalles suivants donnés dans un ordre de préférence [2 ; 6] ; [3,5 ; 5]; à une température (°C) d'étirage comprise dans les intervalles suivants donnés dans un ordre croissant de préférence : [95 ; 150] [105 ; 145] [110; 145];
- l'étirage surfacique (taux d'étirage longitudinal * taux d'étirage transversal) est compris entre 4 et 25 et de préférence entre 4 et 20;

VI. Pour obtenir une valeur de module sonique planaire global GPSM mesurée par la méthode B inférieure à 440 daN/mm$^2$, et par suite une résistance à l'hydrolyse mesurée dans un test PCT 36h 125°C et donnée par un taux de rétention de l'Allongement à la Rupture (AR) sens MD inférieur à 50%:

- l'étirage longitudinal est effectué avec un taux d'étirage compris entre [2 ; 6] ; à une température (°C) d'étirage comprise dans les intervalles suivants donnés dans un ordre croissant de préférence : [70 ; 150]; [85 ; 150]; [95;145];
- l'étirage transversal est effectué avec un taux d'étirage compris entre [2 ; 6] ; à une température (°C) d'étirage comprise dans les intervalles suivants donnés dans un ordre croissant de préférence : [95 ; 150]; [105 ;150]; [110 ;150];
- l'étirage surfacique (taux d'étirage longitudinal * taux d'étirage transversal) est compris entre 4 et 25, de préférence entre 4 et 20 et plus préférentiellemnt encore entre 4 et 12.

Selon un autre de ses aspects, l'invention concerne un film polyester biétiré, notamment celui obtenu par le procédé selon l'invention, ce film étant caractérisé par:

(i) une résistance à l'hydrolyse mesurée dans un test PCT 36h 125°C et donnée par un taux de rétention de l'Allongement à la Rupture (AR) sens MD, compris dans les intervalles suivants donnés dans un ordre croissant de préférence et en %: [<50%] ; [50 ; 70]; [>70%];
(ii) une résistance au choc-traction comprise dans les intervalles suivants donnés dans un ordre croissant de préférence et en kJ/m$^2$ : [<240] ; [240 ; 300]; [>300];
(iii) et/ou par une valeur de module sonique planaire global GPSM comprise dans les intervalles suivants donnés dans un ordre croissant de préférence et en daN/mm$^2$ : [<440] ; [440 ; 470]; [>470].

Selon encore un autre de ses aspects, l'invention concerne un module, panneau ou cellule photovoltaïque équipé d'au moins un film selon l'invention.
Selon encore un autre de ses aspects, l'invention concerne l'utilisation d'au moins un film selon l'invention, pour la fabrication d'un module, d'un panneau ou d'une cellule photovoltaïque.

**Description détaillée de l'invention**

Selon une caractéristique essentielle de l'invention, on exploite le fait que le comportement à l'hydrolyse d'un film dans un environnement naturel puisse être prédit par l'étude de la résistance au choc-traction et/ou l'étude des module sonique du film polyester.
Selon l'invention la production industrielle de films polyesters se fait suivant un procédé de biétirage que l'on peut décomposer en plusieurs étapes (a) à (n).

(A)- PROCEDE

*Etape (a) - Matière première*

La matière première à base de polyester mise en oeuvre dans le procédé selon l'invention est obtenue par:

I. Nature et synthèse de différents polymères et préférablement des PET(s)
II. ajout des charges et additifs

I. (1) Nature

Les films polyesters plus spécialement visés sont par exemple des polyesters aromatiques et particulièrement le polyéthylène téréphtalate PET (e.g. à orientation biaxiale) ou le polyéthylène naphtalate (PEN) ou le polybutylène téréphtalate (PBT).

Quand le film polyester est un polyester aromatique, il s'agit de préférence d'un polyester aromatique essentiellement linéaire, obtenu à partir d'un diacide aromatique ou d'un ester dérivé dudit acide, et d'un diol ou d'un ester dérivé de ce diol.

Le polyester constituant le film de base peut être choisi parmi les polyesters auxquels on fait appel habituellement pour l'obtention de films semi-cristallins biorientés. Il s'agit de polyesters linéaires filmogènes, cristallisables par orientation et obtenus de façon usuelle à partir d'un ou plusieurs acides aromatiques dicarboxyliques ou leurs dérivés (esters d'alcools aliphatiques inférieurs ou halogénures par exemple) et d'un ou plusieurs diols (glycols) aliphatiques.

Comme exemples d'acides aromatiques, on peut citer les acides phtalique, téréphtalique, isophtalique, naphtalènedicarboxylique-2,5, naphtalène-dicarboxylique-2,6, furane dicarboxylique-2,5. Ces acides peuvent être associés à une quantité mineure d'un ou plusieurs acides dicarboxyliques aliphatiques ou cycloaliphatiques, tels que les acides adipique, azélaïque, tétra- ou hexahydrotéréphtalique.

Comme exemples non limitatifs de diols aliphatiques, on peut citer l'éthylèneglycol, le propanediol-1,3, le butanediol-1,4, l'isosorbide ou 1,4:3,6-dianhydro-D-sorbitol. Ces diols peuvent être associés à une quantité mineure d'un ou plusieurs diols aliphatiques plus condensés en carbone (néopentylglycol par exemple) ou cycloaliphatiques (cyclohexanedimethanol).

Préférentiellement, les polyesters filmogènes cristallisables sont des polytéréphtalates ou des polynaphtalènedicarboxylates d'alkylènediol et, en particulier, le polyteréphtalate d'éthylèneglycol (PET) ou de butanediol-1,4 ou des copolyesters comportant au moins 80 % en moles de motifs téréphtalate d'éthylèneglycol. Avantageusement, le polyester est un polytéréphtalate d'éthylèneglycol dont la viscosité intrinsèque mesurée à 25°C dans l'orthochlorophénol est comprise entre 0,6 et 1,20 dl/g.

Les films de polyester biorientés sont, par exemple:

➢ soit constitués de polyéthylène téréphtalate ;
➢ soit il s'agit de mélanges ou non de copolyesters polyéthylène téréphtalate contenant des unités cyclohexyl diméthylol à la place des unités éthylène
➢ soit composés de mélanges ou non de copolyesters polyéthylène téréphtalate avec une partie de polyester présentant des unités isophtalate
➢ soit composés de mélanges ou non de copolyesters polyéthylène téréphtalate avec une partie de polyester présentant des unités isophtalate et une partie contenant des unités cyclohexyl diméthylol à la place des unités éthylène
➢ soit constitués de plusieurs couches de polyesters de natures chimiques différentes, comme décrit précédemment, obtenus par coextrusion.

Des exemples spécifiques de polyesters aromatiques sont notamment le polyéthylène téréphtalate, le polyéthylène isophtalate, le polybutylène téréphtalate, le poly-(diméthyl-1,4-cyclohexylènetéréphtalate le polyéthylènefuranoate (PEF) et le polyéthylène-2,6-naphtalènedicarboxylate. Le polyester aromatique peut être un copolymère de ces polymères ou un mélange de ces polymères avec une petite quantité d'autres résines, par exemple et sans être limitatif le polybutylène téréphtalate (PBT). Parmi ces polyesters, le polyéthylène téréphtalate (PET) et le polyéthylène-2,6-naphtalènedicarboxylate (PEN) sont particulièrement préférés car ils offrent un bon équilibre entre les propriétés physiques, les propriétés mécaniques, les propriétés thermiques et les propriétés optiques.

I.(2) Synthèse

Par exemple, l'acide téréphtalique ou dérivés, et l'éthylène glycol sont soumis à une réaction d'estérification ou de transestérification par une méthode bien connue. Des exemples de catalyseur de la réaction comprennent des composés de métaux alcalins, des composés de métaux alcalino-terreux, des composés à base de zinc, plomb, manganèse, cobalts, aluminium, antimoine et titane. Des exemples d'agents colorants comprennent des composés phosphorés. Il est préférable d'ajouter un composé à base d'antimoine, de germanium, ou de titane en tant que catalyseur de polymérisation. Pour une telle méthode, dans le cas d'une addition d'un composé à base de germanium par exemple, il est préférable d'ajouter le composé à base de germanium sous forme de poudre.

La résine de polyester utilisé dans la présente invention a un poids moléculaire moyen en nombre compris entre 18000 et 40000 et une viscosité intrinsèque IV comprise entre 0,6 et 1,2 dL/g. Une étape additionnelle de polymérisation en phase solide peut être mise en oeuvre afin d'obtenir les poids moléculaires les plus élevés comme cité ci-dessus. Cette méthode comprend l'étape de polymérisation d'une résine polyester usuelle, ayant un poids moléculaire en nombre moyen de 18000, l'étape de chauffage entre 190°C et une température inférieure au point de fusion de la résine polyester sous pression réduite ou circulation de gaz inerte tel que l'azote. La méthode permet d'accroitre le poids moléculaire en nombre moyen sans accroitre la quantité de groupes carboxyliques terminaux de la résine polyester.

II. L'ajout de charges et d'additifs

Des charges telles que les oxydes de titane, silice, aluminium, zinc, étain, ainsi que le sulfate de baryum, carbonate de calcium, noir de carbone, kaolin, carbure de silicium, les particules réticulées inorganiques telles que les acryliques, silicones, polystyrène, mélamine, les polymères incompatibles, et leurs mélanges, sont préférablement ajouté dans le polyester sous forme de masterbatches à base de PET.

Les additifs tels que les stabilisants anti-UV, absorbeurs UV, antioxydants, inhibiteurs radicalaires, HALS, les allongeurs de chaines, les agents antistatiques, les lubrifiants organiques, les retardateurs de flamme et leurs mélanges sont préférablement ajouté dans le polyester sous forme de masterbatches à base de PET.

De façon à garantir une masse moléculaire moyenne comprise entre 18000 et 40000 soit une viscosité intrinsèque comprise entre 0,6 et 1,2, les MB à base de PET introduits présentent une viscosité intrinsèque IV suffisante et contrôlée. L'obtention de tels MB peut nécessiter un post traitement de polymérisation en phase solide.

*Etape (b) - Séchage de_la_matière première*

Cette étape facultative de séchage de la matière première vise à atteindre une teneur limite en humidité prédéterminée sous agitation fluidique ou mécanique en présence d'un média sec (point de rosée -70°C). En effet, les polyesters, en particulier le PET sont hygroscopiques : les granulés absorbent l'eau, et, en conséquence, la masse molaire, l'indice limite de viscosité et les propriétés mécaniques diminuent d'une façon significative. Pour cette raison, il est préférable que les granulés de matière première soient séchés avant extrusion afin que le taux d'humidité soit par exemple inférieur ou égal à 50 ppm en masse.

*Etape_(c) Eventuel mélange de la matière première*

La méthode de fabrication d'un film PET mono- ou multicouche formé à partir du polymère décrit précédemment peut inclure, si nécessaire (notamment quand des extrudeuses monovis sont utilisées), l'usage de mélangeurs statiques ou équipements assimilés, dans les canaux menant à la boite d'alimentation pour favoriser l'homogénéisation des flux de matières.

*Etape (d) Extrusion (alimentation, compression, fusion et homogénéisation) de la matière première*

Cette étape (d) comprend les sous-étapes d'alimentation, compression, fusion et homogénéisation de la matière première dans des outillages spécialisés situés en amont de la filière qui rend la matière première malléable. La fabrication d'un film mono ou multicouche peut impliquer une ou plusieurs extrudeuses. Le chauffage des extrudeuses est réalisé par média fluidique ou électrique.

Le film de polyester est obtenu par extrusion d'une nappe de polymère fondu au travers d'une filière plate ou multicanaux.

*Etape (e) Refroidissement/trempe*

La nappe de polymère fondu est immédiatement trempée et solidifiée sur un système de refroidissement tel qu'un tambour de coulée refroidi pour obtenir un film non orienté amorphe. La nappe est alors trempée et solidifiée pour donner un film amorphe non orienté. L'efficacité du refroidissement nécessite un contact intime entre la nappe et le tambour de coulée. Ce contact est obtenu par exemple par placage électrostatique, ou lame d'air, ménisque d'eau, boite à dépression, humidification au glycol et autres méthodes de l'état de l'art. Toutes ces méthodes peuvent aussi être combinées.

### Eventuelle Etape (f) d'enduction:

Le procédé de la présente invention peut comprendre une étape (f) de traitement chimique par enduction en ligne sur une face ou deux faces du film, de résines en solution ou en dispersion, aqueuses ou solvantées ou sans solvant, visant à conférer des propriétés spécifiques au film.

Ce dépôt peut être réalisé par des méthodes de transfert telles que rouleaux gravés, barres hélicoïdales lisseuses, lame d'air, ou tout autre méthode connue de l'état de l'art. Le film peut aussi subir un traitement physique tel que traitement UV, plasma, corona.

### Etape (g) Etirage biaxial

Ce film non orienté amorphe est alors étiré une ou plusieurs fois, avec un taux d'étirage compris entre 2 et 6, dans la direction longitudinale à une température comprise entre la température de transition vitreuse Tg1 du film amorphe et une température égale à Tg1+60°C, puis le film monoétiré est à nouveau étiré dans la direction transversale avec un taux d'étirage entre 2 et 6 à une température entre Tg2 température de transition vitreuse du film monoétiré et Tg2+60°C.

Le film amorphe non orienté obtenu après l'étape (e) ou l'étape éventuelle (f) peut être soumis à un étirage biaxial. Le terme « étirage biaxial » se réfère à un étirage dans les directions longitudinale et transversale. L'étirage peut être un étirage biaxial séquentiel, quelque soit l'ordre des séquences, ou un étirage biaxial simultané. De plus, un nouvel étirage peut être effectué dans la direction longitudinale et/ou transversale.

Le terme « étirage dans la direction longitudinale » se réfère à un étirage produisant une orientation moléculaire dans la direction longitudinale du film. Cet étirage est le plus souvent produit par deux jeux de rouleaux animés de vitesses différentes $v1$ et $v2$ entre lesquels est placé un dispositif de chauffage permettant de porter le film à une température comprise entre sa température de transition vitreuse et sa température de fusion. Le rapport des vitesses $v1/v2$ est appelé taux d'étirage.

L'étirage peut être effectué en une seule étape ou en plusieurs étapes avec plusieurs paires de rouleaux. Le taux d'étirage dépend du type de résine. La méthode d'étirage peut être une combinaison de chauffage par rouleau de contact et d'autres moyens de chauffage, comme par exemple des panneaux radiants de courtes ou moyenne longueur d'onde, des rubans chauffants, un flux d'air chaud par des buses à air, et tout autre moyen connu de l'état de l'art. Toutes ces méthodes peuvent aussi être combinées.

- En général, l'étirage longitudinal est effectué avec un taux d'étirage compris entre 2 et 6 à une température (°C) d'étirage comprise entre 85 et 140°C;
- l'étirage transversal est effectué avec un taux d'étirage compris entre 2 et 6 à une température (°C) d'étirage comprise entre 105 et 145°C ;
- et/ou le taux d'étirage surfacique (taux d'étirage longitudinal * taux d'étirage transversal) est compris entre 4 et 25.

Par exemple, pour le PET, le taux d'étirage longitudinal est préférablement compris entre 2 et 6. Si le biétirage du film est généralement séquentiel avec la première orientation dans la direction longitudinale, il est aussi possible d'orienter d'abord dans le sens transversal, ou d'utiliser un étirage simultané.

Ensuite, afin d'étirer le film dans la direction transversale, le film est maintenu entre des pinces qui circulent dans des rails divergents, étirant ainsi le film dans la direction transversale (perpendiculaire au sens machine).

Les chaines macromoléculaires du film obtenu selon le procédé décrit sont alors orientées selon 2 axes privilégiés dans le plan du film.

### Eventuelle Etape (h) Enduction:

Le procédé de la présente invention peut comprendre une étape (h) de traitement chimique par enduction en ligne sur une face ou deux faces du film, de résines en solution ou en dispersion, aqueuses ou solvantées ou sans solvant, visant à conférer des propriétés spécifiques au film. Ce dépôt peut être réalisé par des méthodes de transfert telles que rouleaux gravés, barres hélicoïdales lisseuses, lame d'air, ou tout autre méthode connue de l'état de l'art. Le film peut aussi subir un traitement physique tel que traitement UV, plasma, corona.

*Etape (i) Thermofixation:*

Dans une étape suivante, un traitement thermique du film biétiré à une température comprise entre 150 et 260°C est réalisé dans le but d'abaisser les contraintes internes résiduelles des étirages afin de stabiliser dimensionnellement le film.

On obtient alors un film d'une grande stabilité dimensionnelle vis-à-vis de la température. Par thermofixation, on piège l'orientation moléculaire générée lors des étirages dans un réseau de cristallites.

*Etape (j) Relaxation transversale- du film,*

Une opération de relaxation par convergence des rails est avantageusement effectuée afin de garantir la variation dimensionnelle en température du film dans son application.

*Etape (k) Bobinage du film*

Le film biétiré et stabilisé dimensionnellement est enroulé en ligne sous forme de bobines mères qui pourront subir les étapes suivantes de transformation.

*Etape (l) de finition*

Cette étape est avantageusement choisie dans le groupe constitué par : découpage (découpage des bobines mères en bobines filles), enduction, métallisation sous vide, recuit, traitement UV, plasma ou corona, et leurs combinaisons;

*Etape (m) de contrôle des Performances du film*

Cette étape de contrôle ou de mesure des performances de résistance à l'hydrolyse du film polyester est réalisée par la méthode A de mesure de la résistance au choc-traction et/ou la méthode B de mesure de module sonique. Ces méthodes prédictives, rapides et universelles sont réalisables dans un temps compatible avec le cycle de production.

*Etape (n) de prise en compte*

Les résultats des mesures faites à l'étape (m) permettent d'agir sur les paramètres procédé de l'étape (g) et/ou (i) en conséquence.

(B) - FILM POLYESTER BIETIRE OBTENU

Le film peut être de structure monocouche, ou coextrudé en multicouches AB, ABA ou ABC (avec les symboles A,B,C correspondant à des couches de nature et composition différente ou identique)

**EXEMPLES**

L'invention sera mise en évidence avec ses avantages apparents au travers des exemples ci-dessous. Les propriétés physiques, les méthodes pour leur évaluation ainsi que les critères d'évaluation utilisés dans la présente invention sont décrits ci-après.

*Propriétés physiques mesurées*

Méthode A : Résistance au choc traction

La résistance au choc-traction consiste à mesurer l'énergie absorbée lors de la rupture d'une éprouvette non entaillée exprimée en kJ/m$^2$ selon la norme ISO-8256 avec un équipement Universal impact Tester de Toyoseiki.

L'éprouvette est rompue lors d'un choc unique se produisant au point le plus bas de l'oscillation du pendule d'une machine de choc-traction. Au moment de la rupture, l'éprouvette est horizontale. L'une des extrémités de l'éprouvette, lors du choc est maintenue par le pendule et l'autre extrémité par le mors de traction.

L'énergie de rupture est déterminée par la valeur de l'énergie cinétique du pendule mesurée pendant le processus de rupture de l'éprouvette. Des corrections sont apportées du fait de l'énergie de rebond du mors de traction.

L'essai de choc est utilisé pour déterminer le comportement des matériaux à vitesses de déformation élevées.

La remontée de la pendule détermine le travail de choc absorbé d'une éprouvette normalisée jusqu'à la rupture en mesurant la remontée du marteau après l'impact.

L'étalonnage de l'appareil s'effectue à vide, c'est-à-dire sans échantillon.

La mesure de l'angle initial $\alpha$ permet de vérifier l'énergie potentielle du pendule dans sa position initiale.

La mesure de l'angle $\alpha'$ (sans éprouvette) permet de vérifier l'énergie potentielle du pendule dans sa position finale, ainsi que la perte d'énergie de rebond.

Typiquement, la mesure de l'angle initial $\alpha$ est de :

$$\alpha = 134.2$$

La mesure de l'angle final $\alpha'$ (sans éprouvette) est :

$$\alpha' = 129.5$$

Dans sa position initiale, l'énergie potentielle E1 du pendule est défini par le poids du pendule W (1.188 kg), la distance entre le centre de gravité du pendule et l'axe de rotation R (0.0492 m) et l'angle initial $\alpha$ (134.2 °) selon la formule :

$$E1 = W . R (1 - \cos \alpha).$$

Une fois que l'éprouvette est rompue, l'énergie potentielle E2 du pendule est défini par le poids du pendule W (1.188 kg), la distance entre le centre de gravité du pendule et l'axe de rotation R (0.0492 m) et l'angle final $\beta$ selon la formule :

$$E2 = W . R (1 - \cos \beta).$$

L'énergie dépensée pour la rupture est définie par le poids du pendule W (1.188 kg), la distance entre le centre de gravité du pendule et l'axe de rotation R (0.0492 m), l'angle initial $\alpha$ (134.2 °), l'angle final à vide $\alpha'$ (129.5 °), l'angle final $\beta$, l'épaisseur du film (en m), ainsi que la largeur de l'échantillon (0.00318 m).

$$E = \frac{W.R.g[(\cos \beta - \cos \alpha) - (\cos \alpha' - \cos \alpha)].(\alpha + \beta) / (\alpha + \alpha')}{\text{Epaisseur x Largeur x10}^3} \quad \text{en kJ/m}^2$$

Méthode B : Module Sonique

La méthode consiste à caractériser l'orientation moléculaire des films en utilisant la technique de mesure de vitesse de propagation des ultrasons grâce à un Sonic Sheet tester SST-250 fabriqué par Nomura Shoji Co ltd au Japon. Il s'agit d'une méthode non destructive permettant de mesurer la vitesse des ultrasons dans le plan du film dans toutes les directions successivement.

L'échantillon est placé sur une platine revêtue d'une matière isolante. On mesure le temps requis entre une lame émettrice et une lame détectrice à travers une distance spécifique selon la norme ASTM F89-68.

Il existe une très bonne corrélation entre l'analyse « SST » et le module de Young qui caractérise la rigidité en traction de l'échantillon dans une direction donnée.

En ce qui concerne les films polyester biétirés, on applique la formule empirique suivante :

$$E_s = 92 \text{ x } v^2$$

Avec :

V = vitesse de propagation des ultrasons exprimée en km/s.

Es = module sonique en daN/mm$^2$

Des mesures d'orientation dans le plan de l'échantillon sont facilitées par la rotation automatique de la platine et le mouvement vertical de la tête de la sonde pendant la rotation de la platine et entre des mesures de vitesse des ultrasons.

Cette méthode est adaptée pour des feuilles ou films d'une épaisseur > 100$\mu$m, dans le cas des feuilles ou films d'une épaisseur <100$\mu$m, il suffit de superposer plusieurs feuilles toute en respectant des directions préférentielles d'orientation.

On caractérise l'orientation dans les directions d'étirage du film biétiré (MD et TD) ainsi qu'une moyenne de 36 mesures tous les 5° pour caractériser l'orientation planaire définie par le module sonique planaire global GPSM.

Résistance à l'hydrolyse (test PCT)

Pour caractériser la résistance à l'hydrolyse, le film polyester est soumis à un vieillissement accéléré PCT (Pressure Cooker Test) dans une enceinte climatique sous pression SYSTEC VE-100 avec les conditions suivantes : température 125°C, humidité relative 100%, pression 2.3 bars. La résistance à l'hydrolyse est directement représentée par le taux de rétention de l'Allongement à la Rupture (AR) du film qui est mesuré après 36h de test de vieillissement. L'allongement à la rupture est mesuré selon la norme ASTM D-882 avec un dynamomètre INSTRON 5543 équipé d'un détecteur de 1kN. La dimension des éprouvettes découpées dans le sens machine (sens MD) c'est-à-dire dans le sens longitudinal du film, est normalisée 100*15 mm. L'allongement à la rupture avant vieillissement est considéré égal à 100%.

Le taux de rétention de l'allongement à la rupture est calculé par le rapport de l'allongement à la rupture des échantillons après vieillissement sur l'allongement à la rupture des échantillons avant vieillissement. Le taux de rétention de l'allongement à la rupture est mesuré après 36 heures de test PCT.

Les échantillons sont évalués selon le classement suivant :

● A: taux de rétention de l'allongement à la rupture >70% considéré comme excellent
● B: taux de rétention de l'allongement à la rupture compris entre 50 et 70% considéré comme acceptable
● C: taux de rétention de l'allongement à la rupture <50% considéré comme insuffisant.

*Viscosité Intrinsèque IV*

Une solution échantillon est obtenue par dissolution d'une quantité donnée d'échantillon (polymère ou film) à une température d'au moins 120°C pendant 30min dans 100ml d'un mélange de solvants 1,2-dichlorobenzene/phenol 50/50. Après refroidissement, le temps d'élution de la solution échantillon est mesurée à l'aide d'un viscosimètre Ubbelhode. La valeure de la viscosité intrinsèque IV est calculée selon la norme ISO 1628/5 en utilisant les correlations suivantes :

La viscosité du mélange de solvants purs $\eta_0$ est comparée à la viscosité de la solution échantillon $\eta$. La viscosité relative $\eta_r$ est donnée par :

$$\eta_r = \eta / \eta_0 = t * \rho / t_0 * \rho_0$$

Avec:

$t_0$ et $\rho_0$ sont respectivement le temps d'élution et la densité du mélange de solvants
$t$ et $\rho$ sont respectivement le temps d'élution et la densité de la solution échantillon.

Etant donné que $\rho \sim \rho_0$ dans notre cas, l'équation permettant d'obtenir la viscosité spécifique $\eta_{sp}$ est obtenue par: $\eta_{sp} = \eta_r - 1 = (t - t) / t_0$

La corrélation entre $\eta_{sp}$ et la viscosité intrinsèque IV est donnée par:

$$(\eta_{sp}/C) = IV + k * IV^2 * C$$

Avec:

($\eta_{sp}$ / C) : nombre de viscosité.

C: concentration du polymère dans la solution

k: constante

La viscosité intrinsèque IV peut être déterminée expérimentalement car il s'agit de l'ordonnée à l'origine de la courbe reliant le nombre de viscosité ($\eta_{sp}$ / C) en fonction de la concentration C pour une concentration nulle.

*Matières premières-Méthodes-Résultats*

Exemple 1

*Etape (a)*

Des granulés de polyéthylène téréphtalate haute viscosité, des granulés de masterbatch blanc haute viscosité à 60% massique de dioxyde de titane (type rutile (Kronos 2220® de Kronos), et des granulés de masterbatch à 20% massique en absorbeur UV (Tinuvin 1600® BASF), sont :

*Etape (b)*

séchés,

*Etape (d)*

fondus et extrudés au travers d'une filière plate.

*Etape (e)*

La nappe fondue est trempée sur un tambour de coulée rotatif et refroidi pour donner un film blanc tricouche non-orienté amorphe.

*Etape (g)*

Le film PET blanc tricouche non-orienté amorphe est soumis à un étirage longitudinal de 4,2 à une température de 110 à 120°C, puis à un étirage transversal de 3,9 à une température de 115°C. Le taux d'étirage surfacique est de 16.4.

*Etape (i)*

Dans cette étape suivante, le film est soumis à un traitement thermique à une température de 209°C.

*Etape (j)*

puis à une relaxation transversale.

*Etape (k&l)*

Le film est ensuite découpé et bobiné

*Etape (m)*

puis évalué selon les méthodes A et B.

*Résultats*

Le film blanc de 50$\mu$m obtenu présente une viscosité intrinsèque de 0,690dL/g.

Les propriétés physiques du film sont décrites dans le tableau 1. Elles sont considérées très satisfaisantes donc l'étape (n) de prise en compte n'est pas mise en oeuvre.

Exemple 2

*Etape (a)*

Des granulés de polyéthylène téréphtalate haute viscosité, sont :

*Etape (b)*

séchés,

*Etape (d)*

fondus et extrudés au travers d'une filière plate.

*Etape (e)*

La nappe fondue est trempée sur un tambour de coulée rotatif et refroidi pour donner un film PET non-orienté amorphe.

*Etape (g)*

Le film PET non-orienté amorphe est soumis à un étirage longitudinal de 3,5 à une température de 110 à 125°C, puis à un étirage transversal de 3,9 à une température de 138°C. Le taux d'étirage surfacique est de 13.4.

*Etape (i)*

Dans cette étape suivante, le film est soumis à un traitement thermique à une température de 206°C.

*Etape (j)*

puis à une relaxation transversale.

*Etape (k&l)*

Le film est ensuite découpé et bobiné

*Etape (m)*

puis évalué selon les méthodes A et B.

*Résultats*

Le film de 125 $\mu$m obtenu présente une viscosité intrinsèque de 0,685dL/g.
Les propriétés physiques du film sont décrites dans le tableau 1. Elles sont considérées satisfaisantes donc l'étape (n) de prise en compte n'est pas mise en oeuvre.

Exemple 3

*Etape (a)*

Des granulés de polyéthylène téréphtalate moyenne viscosité sont :

*Etape (b)*

séchés,

*Etape (d)*

fondus et extrudés au travers d'une filière plate.

*Etape (e)*

La nappe fondue est trempée sur un tambour de coulée rotatif et refroidi pour donner un film PET non-orienté amorphe.

*Etape (g)*

Le film PET non-orienté amorphe est soumis à un étirage longitudinal de 2,8 à une température de 115 à 130°C, puis à un étirage transversal de 3,8 à une température de 138°C. Le taux d'étirage surfacique est de 10,8.

*Etape (i)*

Dans cette étape suivante, le film est soumis à un traitement thermique à une température de 216°C.

*Etape (j)*

puis à une relaxation transversale.

*Etape (k&l)*

Le film est ensuite découpé et bobiné

*Etape (m)*

puis évalué selon les méthodes A et B.

### *Résultats*

Le film de 250$\mu$m obtenu présente une viscosité intrinsèque de 0,650dL/g.
Les propriétés physiques du film sont décrites dans le tableau 1. Elles sont considérées insuffisantes donc l'étape (n) de prise en compte est mise en oeuvre afin d'agir sur les paramètres du procédé pour ajuster les propriétés du film en cours de fabrication.OK RF

*Etape (n) de prise en compte*

Les valeurs de GPSM et de résistance au choc traction mesurées lors de l'étape (m) permettant de prédire une résistance à l'hydrolyse mesurée dans un test PCT 36h 125°C et donnée par un taux de rétention de l'Allongement à la rupture sens MD <50%, les paramètres d'étirage de l'étape (g) et/ou (i) du film de l'exemple 3 sont modifiés en conséquence pour donner l'exemple 4.

Exemple 4

*Etape (a)*

Des granulés de polyéthylène téréphtalate moyenne viscosité sont :

*Etape (b)*

séchés,

*Etape (d)*

fondus et extrudés au travers d'une filière plate.

*Etape (e)*

La nappe fondue est trempée sur un tambour de coulée rotatif et refroidi pour donner un film PET non-orienté amorphe.

*Etape (g)*

Le film PET non-orienté amorphe est soumis à un étirage longitudinal de 3,15 à une température de 115 à 130°C, puis à un étirage transversal de 3,9 à une température de 138°C. Le taux d'étirage surfacique est de 12,3.

*Etape (i)*

Dans cette étape suivante, le film est soumis à un traitement thermique à une température de 215°C.

*Etape (j)*

puis à une relaxation transversale.

*Etape (k&l)*

Le film est ensuite découpé et bobiné

*Etape (m)*

puis évalué selon les méthodes A et B.

*Résultats*

Le film de 250$\mu$m obtenu présente une viscosité intrinsèque de 0,650dL/g.

Les propriétés physiques du film sont décrites dans le tableau 1. Elles sont considérées satisfaisantes.

**Tableau 1 :**

| Films exemple | Taux rétention AR 36h 125°C sens MD | Résistance au Choc traction | GPSM |
|---|---|---|---|
| Exemple 1 | A (79%) | 336 kJ/m$^2$ | 485 daN/mm$^2$ |
| Exemple 2 | B (63%) | 270 kJ/m$^2$ | 450 daN/mm$^2$ |
| Exemple 3 | C (24%) | 167 kJ/m$^2$ | 429 daN/mm$^2$ |
| Exemple 4 | B (51%) | 242 kJ/m$^2$ | 442 daN/mm$^2$ |

**Revendications**

1. Procédé de fabrication d'un film polyester, de préférence un film polyéthylène téréphtalate PET biétiré; **caractérisé en ce qu'**il comprend les étapes suivantes:

   (a) Mise en oeuvre d'une matière première constituée d'éléments discrets, de préférence des granulés, à base de polyester de poids moléculaire moyen en nombre compris entre 15000 et 50000, de préférence entre 18000 et 40000, et une viscosité intrinsèque (IV) comprise entre 0,4 et 1,3 dL/g, de préférence entre 0,6 et 1,2 dL/g;
   (b) Séchage de la matière première;
   (c) Eventuel mélange de la matière première;
   (d) Extrusion (alimentation, compression, fusion et homogénéisation) de la matière première au travers d'au moins une filière pour former un film mono ou multicouche;
   (e) Refroidissement du film extrudé à l'étape (d);
   (f) Eventuelle enduction sur une face ou deux faces du film à l'aide de résine(s), de façon à conférer des propriétés spécifiques au film;
   (g) Etirage biaxial du film obtenu à l'étape (e) selon un taux d'étirage et à une température d'étirage choisis de manière à orienter les chaines macromoléculaires selon 2 axes privilégiés dans le plan du film et à obtenir un taux de cristallinité représentant de 10 à 50 %, de préférence de 25 à 35 % en poids du film,;

(h) Eventuelle enduction sur une face ou deux faces du film à l'aide de résine(s), de façon à conférer des propriétés spécifiques au film;

(i) Thermofixation du film,

(j) Relaxation transversale du film,

(k) Bobinage du film,

(l) Finition du film choisie de préférence dans le groupe constitué par : découpage, enduction, métallisation sous vide, recuit, traitement UV, plasma ou corona, et leurs combinaisons ;

(m) Contrôle des performances du film polyester par la méthode A de mesure de la résistance au choc-traction et/ou la méthode B de mesure de module sonique;

(n) Prise en compte des mesures de l'étape (m) pour modifier au besoin les paramètres d'au moins l'une des étapes suivantes : (g) et (i), de façon à contrôler la résistance à l'hydrolyse du film.

**2.** Procédé selon la revendication 1 **caractérisé en ce qu'**il comprend au moins l'un des trois modes (I, II, III) suivants de contrôle des paramètres opératoires, ces 3 modes étant donnés ci-après dans un ordre décroissant de préférence:

I. Pour obtenir une résistance au choc-traction du film mesurée par la méthode A supérieure à 300 kJ/m$^2$, et par suite une résistance à l'hydrolyse mesurée dans un test PCT 36h 125°C et donnée par un taux de rétention de l'Allongement à la Rupture (AR) sens MD supérieur à 70%;

- l'étirage longitudinal est effectué avec un taux d'étirage compris dans les intervalles suivants donnés dans un ordre croissant de préférence : [2 ; 6] ; [2,5 ; 5]; [2,9 ; 4,5]; à une température (°C) d'étirage comprise dans les intervalles suivants donnés dans un ordre croissant de préférence [70 ; 150] [85 ; 140] ; [90 ; 135];
- l'étirage transversal est effectué avec un taux d'étirage compris dans les intervalles suivants donnés dans un ordre croissant de préférence : [2 ; 6] ; [3,5 ; 5]; [3,9 ; 4,5]; à une température (°C) d'étirage comprise dans les intervalles suivants donnés dans un ordre croissant de préférence : [95 ; 150] [105 ; 145] ; [110 ; 140]
- l'étirage surfacique (taux d'étirage longitudinal * taux d'étirage transversal) est compris dans les intervalles suivants donnés dans un ordre croissant de préférence : [4 et 25] ; [7 et 25] ; [11 ;25]

II. Pour obtenir une résistance au choc-traction du film mesurée par la méthode A comprise entre 240 et 300 kJ/m$^2$, et par suite une résistance à l'hydrolyse mesurée dans un test PCT 36h 125°C et donnée par un taux de rétention de l'Allongement à la Rupture (AR) sens MD compris entre 50 et 70%

On met en oeuvre une étape (g) d'étirage avec des paramètres choisis tels que:

- l'étirage longitudinal est effectué avec un taux d'étirage compris entre 2 et 6, de préférence entre 2,5 et 5; à une température (°C) d'étirage comprise entre 70 et 150, de préférence entre 90 et 140;
- l'étirage transversal est effectué avec un taux d'étirage compris entre 2 et 6, de préférence entre 3,5 et 5; à une température (°C) d'étirage comprise entre 95 et 150, de préférence entre 110 et 145;
- l'étirage surfacique (taux d'étirage longitudinal * taux d'étirage transversal) est compris entre 4 et 25 et de préférence entre 4 et 20;

III. Pour obtenir une résistance au choc-traction du film mesurée par la méthode A inférieure à 240 kJ/m$^2$, et par suite une résistance à l'hydrolyse mesurée dans un test PCT 36h 125°C et donnée par un taux de rétention de l'Allongement à la Rupture (AR) sens MD inférieur à 50% :

- l'étirage longitudinal est effectué avec un taux d'étirage compris entre [2 ; 6] ; à une température (°C) d'étirage comprise dans les intervalles suivants donnés dans un ordre croissant de préférence : [85 ;150] ; [95;145];
- l'étirage transversal est effectué avec un taux d'étirage compris entre [2 ; 6] ; à une température (°C) d'étirage comprise dans les intervalles suivants donnés dans un ordre croissant de préférence : [105 ;150] ; [110 ;150]
- l'étirage surfacique (taux d'étirage longitudinal * taux d'étirage transversal) est - compris entre 4 et 20 et de préférence entre 4 et 12.

**3.** Procédé selon la revendication 1 ou 2 **caractérisé en ce qu'**il comprend au moins l'un des trois modes (IV, V, VI) suivants de contrôle des paramètres opératoires, ces 3 modes étant donnés ci-après dans un ordre décroissant de préférence:

IV. Pour obtenir une valeur de module sonique planaire global GPSM mesurée par la méthode B supérieure à 470 daN/mm$^2$, et par suite une résistance à l'hydrolyse mesurée dans un test PCT 36h 125°C Met donnée par un taux de rétention de l'Allongement à la Rupture (AR) sens MD supérieur à 70%:

- l'étirage longitudinal est effectué avec un taux d'étirage compris dans les intervalles suivants donnés dans un ordre croissant de préférence : [2 ; 6] ; [2,5 ; 5]; [2,9 ; 4,5]; à une température (°C) d'étirage comprise dans les intervalles suivants donnés dans un ordre croissant de préférence [70 ; 150] [85 ; 140] ; [90 ; 135];
- l'étirage transversal est effectué avec un taux d'étirage compris dans les intervalles suivants donnés dans un ordre croissant de préférence : [2 ; 6] ; [3,5 ; 5]; [3,9 ; 4,5]; à une température (°C) d'étirage comprise dans les intervalles suivants donnés dans un ordre croissant de préférence : [95 ; 150] [105 ; 145] ; [110 ; 140];
- l'étirage surfacique (taux d'étirage longitudinal * taux d'étirage transversal) est compris dans les intervalles suivants donnés dans un ordre croissant de préférence : [4 et 25] ; [7 et 25] ; [11 ;25];

V. Pour obtenir une valeur de module sonique planaire global GPSM mesurée par la méthode B comprise entre 440 et 470 daN/mm$^2$, et par suite une résistance à l'hydrolyse mesurée dans un test PCT 36h 125°C et donnée par un taux de rétention de l'Allongement à la Rupture (AR) sens MD compris entre 50 et 70%:

On met en oeuvre une étape (g) d'étirage avec des paramètres choisis tels que:

- l'étirage longitudinal est effectué avec un taux d'étirage compris dans les intervalles suivants donnés dans un ordre croissant de préférence [2 ; 6] ; [2,5 ; 5]; à une température (°C) d'étirage comprise dans les intervalles suivants donnés dans un ordre croissant de préférence [70 ; 150] [90; 140] ;
- l'étirage transversal est effectué avec un taux d'étirage compris entre les intervalles suivants donnés dans un ordre de préférence [2 ; 6] ; [3,5 ; 5]; à une température (°C) d'étirage comprise dans les intervalles suivants donnés dans un ordre croissant de préférence : [95 ; 150] [110; 145]
- l'étirage surfacique (taux d'étirage longitudinal * taux d'étirage transversal) est - compris entre 4 et 25 et de préférence entre 4 et 20;

VI. Pour obtenir une valeur de module sonique planaire global GPSM mesurée par la méthode B inférieure à 440 daN/mm$^2$, et par suite une résistance à l'hydrolyse mesurée dans un test PCT 36h 125°C et donnée par un taux de rétention de l'Allongement à la Rupture (AR)sens MD inférieur à 50%:

- l'étirage longitudinal est effectué avec un taux d'étirage compris entre [2 ; 6] ; à une température (°C) d'étirage comprise dans les intervalles suivants donnés dans un ordre croissant de préférence : [85 ; 150] ; [95;145];
- l'étirage transversal est effectué avec un taux d'étirage compris entre [2 ; 6] ; à une température (°C) d'étirage comprise dans les intervalles suivants donnés dans un ordre croissant de préférence : [105 ;150] ; [110 ;150]
- l'étirage surfacique (taux d'étirage longitudinal * taux d'étirage transversal) est
- compris entre 4 et 20 et de préférence entre 4 et 12.

4.  Film polyester biétiré, notamment celui obtenu par le procédé selon l'une au moins des revendications précédentes **caractérisé par**:

(i) une résistance à l'hydrolyse mesurée dans un test PCT 36h 125°C et donnée par un taux de rétention de l'Allongement à la Rupture (AR) sens MD compris dans les intervalles suivants donnés dans un ordre croissant de préférence et en %: [<50%] ; [50 ; 70]; [>70%];
(ii) une résistance au choc-traction comprise dans les intervalles suivants donnés dans un ordre croissant de préférence et en kJ/m$^2$ : [<240] ; [240 ; 300]; [>300];
(iii) et/ou par une valeur de module sonique planaire global GPSM comprise dans les intervalles suivants donnés dans un ordre croissant de préférence et en daN/mm$^2$ : [<440] ; [440 ; 470]; [>470].

5.  Module, panneau ou cellule photovoltaïque équipé d'au moins un film selon la revendication 4 ou un film obtenu par le procédé selon l'une au moins des revendications précédentes.

**6.** Utilisation d'au moins un film défini dans l'une au moins des revendications précédentes, pour la fabrication d'un module, d'un panneau ou d'une cellule photovoltaïque.